# EUROPEAN PATENT APPLICATION

(11) **EP 4 776 332 A1**
(43) Date of publication of application: **15.07.2026**
(21) Application number: 25151657.1
(22) Date of filing: 14.01.2025
(51) Int. Cl.: H01L 23/00, H01L 23/36, H01L 23/367

(54) **SEMICONDUCTOR PACKAGE HAVING A WIRE OR RIBBON BONDED HEATSINK**

(71) Applicant: Infineon Technologies Austria AG, 9500 Villach (AT)
(72) Inventor: HEITZER, Ludwig, 94350 Falkenfels (DE); MEYER, Thorsten, 93053 Regensburg (DE); SCHARF, Thorsten, 93138 Lappersdorf - Kareth (DE)
(74) Representative: Lambsdorff & Lange Patentanwälte Partnerschaft mbB

(57) **Abstract**

A semiconductor package includes a semiconductor chip having a first surface and a second surface opposite the first surface. The semiconductor chip is a lateral semiconductor device. A plurality of chip pads is arranged on the first surface of the semiconductor chip. The semiconductor chip is mounted on a carrier, wherein the semiconductor chip is bonded to the carrier with the first surface facing the carrier. A heatsink is disposed over the semiconductor chip. The heatsink is bonded to the semiconductor chip with the second surface of the semiconductor chip facing the heatsink. A conductor loop is bonded to the carrier, wherein a loop section of the conductor loop is connected to the heatsink. The conductor is a wire or a ribbon.

## Description

### Technical Field

This disclosure relates generally to the field of semiconductor die packaging, and in particular to the field of semiconductor packages having a heatsink.

### Background

Semiconductor device manufacturers are constantly striving to increase the performance of their products, while decreasing their cost of manufacture. A cost and device performance sensitive area in the manufacture of a semiconductor device is packaging the semiconductor die. Packaging involves encapsulating the semiconductor die and forming an interconnect from die pads to package terminals. The packaging concept and interconnect technology should provide for high electrical and thermal performance and reliability of the semiconductor device. They should further support package scalability and die shrinkage.

Some types of packages use a heatsink thermally coupled to the semiconductor chip. The heatsink provides a thermal mass for heat spreading in the package and may, e.g., be used for a topside cooling option of the package. In addition, depending on the type of semiconductor chip, the heatsink may perform certain electrical functions that either improve the performance of the semiconductor package or enable the semiconductor package to function at all.

In view of advanced substrate technologies using organic substrates with limited temperature stability, heatsink assembly may become more difficult in future.

### Summary

According to a first aspect of the disclosure, a semiconductor package includes a semiconductor chip having a first surface and a second surface opposite the first surface. The semiconductor chip is a lateral semiconductor device. A plurality of chip pads is arranged on the first surface of the semiconductor chip. The semiconductor chip is mounted on a carrier, wherein the semiconductor chip is bonded to the carrier with the first surface facing the carrier. A heatsink is disposed over the semiconductor chip. The heatsink is bonded to the semiconductor chip with the second surface of the semiconductor chip facing the heatsink. A conductor loop is bonded to the carrier, wherein a loop section of the conductor loop is connected to the heatsink, wherein the conductor is a wire or a ribbon.

According to a second aspect of the disclosure, a semiconductor package includes a semiconductor chip having a first surface and a second surface opposite the first surface. A chip pad is arranged on the first surface of the semiconductor chip. The semiconductor chip is mounted on a carrier, wherein the semiconductor chip is bonded to the carrier with the first surface facing the carrier. A heatsink is disposed over the semiconductor chip. The heatsink is bonded to the semiconductor chip with the second surface of the semiconductor chip facing the heatsink. A conductor loop is bonded to the carrier, wherein a loop section of the conductor loop passes over the semiconductor chip and extends between the semiconductor chip and the heatsink, wherein the conductor is a wire or a ribbon.

The disclosure also comprises methods of manufacturing the semiconductor package according to the first aspect of the disclosure and the semiconductor package according to the second aspect of the disclosure.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1 is a schematic top side perspective view illustrating a standard semiconductor package having a heatsink disposed over a semiconductor chip.
Figure 2A is a schematic top side perspective view of an example of a semiconductor package (without heatsink) according to the first aspect of the disclosure.
Figure 2B is a schematic top side perspective view of another example of a semiconductor package (without heatsink) according to the first aspect of the disclosure.
Figure 2C is a schematic side view of any of the semiconductor packages of Figures 2A and 2B from viewing direction V1 after bonding the heatsink to the semiconductor chip.
Figure 2D is a schematic side view of the semiconductor package of Figure 2B from viewing direction V2 after bonding the heatsink to the semiconductor chip.
Figure 3A is a schematic top side perspective view of an example of a semiconductor package (without heatsink) according to the second aspect of the disclosure.
Figure 3B is a schematic side view of the semiconductor package of Figure 3A from viewing direction V1 before bonding the heatsink to the semiconductor chip.
Figure 3C is a schematic side view of the semiconductor package of Figures 3A and 3B from viewing direction V1 after bonding the heatsink to the semiconductor chip.
Figure 3D is a schematic side view of the semiconductor package of Figures 3A to 3C from viewing direction V2 after bonding the heatsink to the semiconductor chip.
Figure 4A is a schematic top side perspective view of an example of a semiconductor package (without heatsink) according to the first and second aspects of the disclosure.
Figure 4B is a schematic top side perspective view of another example of a semiconductor package (without heatsink) according to the first and second aspect of the disclosure.
Figure 4C is a schematic side view of any of the semiconductor packages of Figures 4A and 4B from viewing direction V1 after bonding the heatsink to the semiconductor chip.
Figure 4D is a schematic side view of the semiconductor packages of Figure 4B from viewing direction V2 after bonding the heatsink to the semiconductor chip.
Figure 5 is a flowchart illustrating exemplary stages of a method of manufacturing a semiconductor device according to the first aspect of the disclosure.
Figure 6 is a flowchart illustrating exemplary stages of a method of manufacturing a semiconductor device according to the second aspect of the disclosure.

### Detailed description

The words "over" or "on" or "beneath" with regard to a part, element or material layer formed or located or disposed or arranged or placed "over" or "on" or "beneath" a surface may be used herein to mean that the part, element or material layer be located (e.g. placed, formed, arranged, disposed, placed, etc.) "directly on" or "directly under", e.g. in direct contact with, the implied surface. The word "over" or "on" or "beneath" used with regard to a part, element or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

In the following examples, a wire is exemplarily used for the conductor. However, it is also possible that the conductor is a ribbon. The conductor (wire or ribbon) may be a separate and/or prefabricated part, which is configured to be bonded to the carrier.

The conductor (wire or ribbon) may, e.g., comprise or be of copper, aluminum gold, silver, palladium coated copper (PCC), etc.

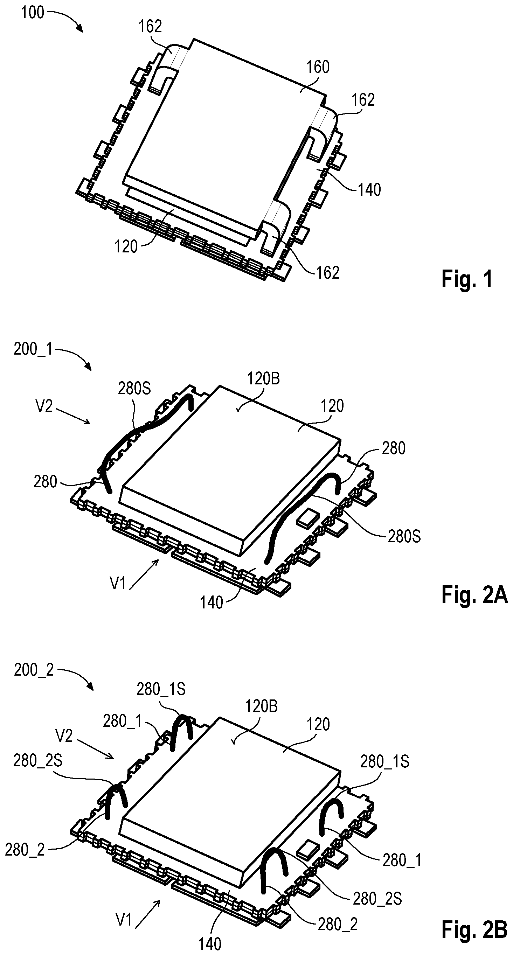

Figure 1 illustrates a standard design of a semiconductor package 100. The semiconductor package 100 includes a semiconductor chip 120 bonded to a carrier 140. A heatsink 160 designed, e.g., as a clip is disposed over the semiconductor chip 120. The heatsink 160 is also referred to as a heatspreader in the art.

In some applications, especially when the semiconductor chip is a GaN device, the heatsink 160 should be on ground potential or source potential. As shown in Figure 1, the heatsink 160 may include bent portions 162 soldered onto the carrier 140. The bent portions 162 may connect the heatsink 160 to ground potential or source potential. Further, the bent portions 162 and may mechanically stabilize the heatsink during heatsink attach.

The semiconductor package 100 of Figure 1, which is not covered by the claims, has the problem that heatsink assembly may be difficult because advanced carrier technologies such as, e.g., laminate substrate, MIS (molded interconnect substrate) or other organic substrates are sensitive against high temperature soldering, which is often used for attaching the heatsink 160 to the carrier 140. Further, the bent (or otherwise structured) portions 162 of the heatsink 160 used for contacting the carrier 140 are expensive to fabricate. If an adhesive or a sinter paste is used instead of solder for attaching the heatsink 160 to the semiconductor chip 120 (e.g., in order to prevent thermal damage of the carrier), a mechanically stable assembly is necessary because of the missing self-alignment effect provided by solder.

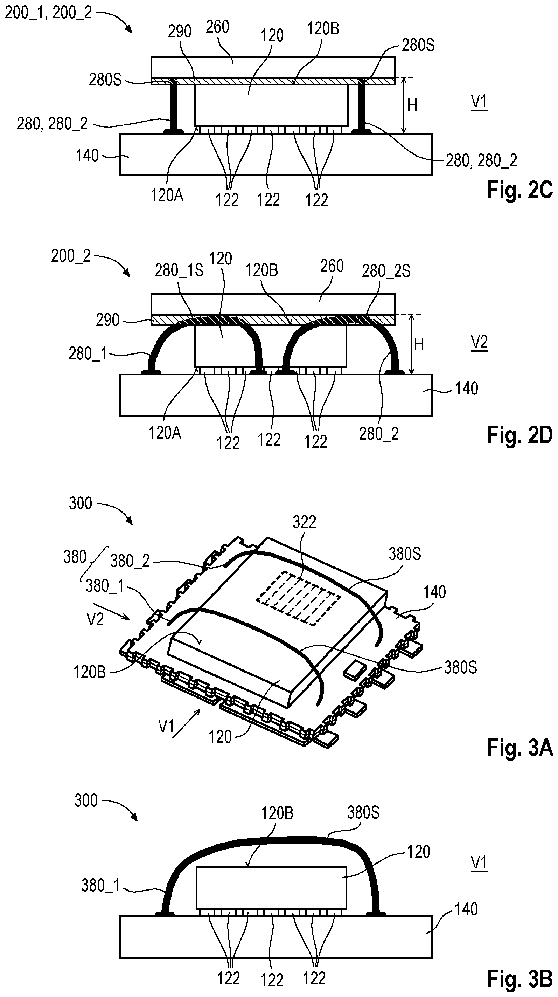

According to a first aspect of the disclosure, Figures 2A to 2D illustrate examples of semiconductor packages 200_1, 200_2 (note that the carrier 140, which is shown as a multi-layer organic carrier in the perspective drawings as an example, is shown schematically as a block in the sectional drawings). It is to be noted that The semiconductor packages 200_1, 200_2 include a semiconductor chip 120 having a first surface 120A and a second surface 120B opposite the first surface 120A. A plurality of chip pads (chip electrodes) 122 are arranged on the first surface 120A of the semiconductor chip 120, see Figures 2C to 2D.

The semiconductor packages 200_1, 200_2 further include a carrier 140 on which the semiconductor chip 120 is mounted. The semiconductor chip 120 is bonded to the carrier 140 with the first surface 120A facing the carrier 140. For example, the chip pads 122 are connected to bond pads (not shown) on the carrier 140.

Similar as in Figure 1, a heatsink 260 (see Figures 2C and 2D) is disposed over the semiconductor chip 120. The heatsink 260 is bonded to the semiconductor chip 120 with the second surface 120B of the semiconductor chip 120 facing the heatsink 260.

The heatsink 260 may, e.g., be a clip. That is, the heatsink 260 may be designed as a metal plate, e.g. a Cu plate. The heatsink 260 may, e.g., be planar and/or may not be structured to include any portion which bonds down to the carrier 140. In particular, the heatsink 260 may not include any bent (or otherwise structured) portions such as, e.g., the bent portions 162 of heatsink 160. That way, the heatsink 260 may be less expensive than a conventional heatsink such as heatsink 160, for example.

The heatsink 260 may be a separate, pre-fabricated part, i.e. not a metal layer deposited on the semiconductor chip 120. The heatsink 260 may provide a substantial thermal mass for heat spreading. The heatsink 260 may have a thickness of equal to or greater than 100 pm, 200 pm, 300 pm, 400 pm or 500 pm.

The semiconductor package 200_1, 200_2 includes a wire loop 280 bonded to the carrier 140. For example, as shown in Figure 2A, two wire loops 280 positioned to extend along opposite sides of the semiconductor chip 120 may be provided.

Each wire loop 280 includes a loop section 280S, which is connected to the heatsink 260. The wire loop 280 may provide an electrical contact between the carrier 140 and the heatsink (e.g. clip) 260. The electrical contact may be used to connect the heatsink 260 to ground potential of the semiconductor package 200_1 or source potential of the semiconductor chip 120 (ground potential and source potential are typically within a margin of a few volts).

As shown in Figure 2A, the loop section 280S may be arranged beside the semiconductor chip 120. For example, the wire loop 280 and the loop section 280S thereof may extend along a lateral side or, if two wire loops 280 are provided, along two opposite lateral sides of the semiconductor chip 120. In the examples shown in Figures 2A to 2D, the loop sections 280S do not pass over the semiconductor chip 120. Rather, the loop sections 280S may, e.g., run parallel to the corresponding lateral side of the semiconductor chip 120.

As shown in Figures 2B and 2D, a semiconductor package 200_2 may include a plurality of wire loops 280_1, 280_2 arranged beside the semiconductor chip 120, e.g. beside one lateral side of the semiconductor chip 120. As shown in Figure 2B, the wire loops 280_1, 280_2 may be arranged along a straight line beside one lateral side of the semiconductor chip 120 and similar wire loops 280_1, 280_2 may be arranged along another straight line beside the opposite side of the semiconductor chip 120. The straight lines may, e.g., be parallel to the corresponding lateral side of the semiconductor chip 120.

Each wire loop 280_1, 280_2 includes a loop section 280_1S and 280_2S, respectively, which is connected to the heatsink 260. The features described for wire loop 280 also apply for wire loops 280_1, 280_2.

The wire loops 280, 280_1, 280_2 may assist down placement and/or heatsink attach of the heatsink 260 on the semiconductor chip 120. For example, wire loops 280, 280_1, 280_2 may, e.g., define a distance or height H between the carrier 140 and the heatsink 260. That is, the distance between the carrier 140 and the heatsink 260 may be controlled during heatsink attach by the wire loops 280, 280_1, 280_2, which are deformed during down placement of the heatsink 260. That way, the position of the heatsink 260 during heatsink attach may be exactly controlled.

As mentioned before, the wire loops 280, 280_1, 280_2 may further provide the electrical contact between the heatsink 260 and the carrier 140 for setting the heatsink 260 on a defined potential (e.g., ground or source potential) without the necessity of soldering the heatsink 260 to the carrier 140.

The material of the wire loops 280, 280_1, 280_2 may, e.g., comprise or be of metal, e.g. Cu, Al, Ag, Au or PCC. The wire loops 280, 280_1, 280_2 may be bonded to the carrier 140 by wire bonding techniques such as, e.g., wedge-bonding or ball-bonding. If the conductor is a ribbon, ribbon-bond techniques may be applied.

The semiconductor chip 120 is, according to the first aspect of the disclosure, a lateral semiconductor device. In lateral semiconductor devices the load current is flowing mainly in a lateral direction between chip pads 122, e.g. load chip pads. In a lateral semiconductor device, the semiconductor chip 120 may have chip pads 122 only on the first surface 120A of the semiconductor chip 120.

The transistor chip 120 may be of different types. According to the first aspect of the disclosure, examples described herein are, in particular, directed to HEMT (high electron mobility transistor) devices. More specifically, the transistor chip 120 referred to herein may, e.g., be a III-V compound semiconductor chip having, e.g., a high band gap. The transistor chip 120 may, e.g., be a GaN chip. In this case, the GaN chip 120 may, e.g., be a lateral GaN-on-substrate device such as a GaN-on-Si device or a GaN-on-SiC device or a GaN-on-sapphire device, for example.

The carrier 140 may, e.g., be a PCB (printed circuit board) or a ceramic-based carrier such as, e.g., a DCB (direct copper bonding) carrier. The examples described herein are particularly directed to organic carriers 140 (such as exemplarily shown in the perspective drawings) that provide a high routability for semiconductor chips 120 (e.g., GaN-type chips) having a pattern of source load pads 122 and a (e.g., interdigitated) pattern of drain load pads 122 on their first surface 120A.

For example, such organic carriers 140 may, e.g., be formed as laminate-based substrates or molded interconnect substrates (MIS). As known in the art, these so-called organic substrates are fabricated by metal plating, structuring and lamination and/or pre-molding processes. These substrates include at least one e.g. metal-plated redistribution layer (RDL) and thus provide a chip-external interconnect with high design variability. They enable the use of a semiconductor transistor chip 120 with low R_{DS(on)} and complex patterns of chip pads 122, since the chip-external RDL of the organic carrier 140 can be used to replace a chip-internal metallization layer on BEoL (Back End of Line) level, that would otherwise be required to provide less complexly designed source and drain load pad layouts (such as, e.g., a single source pad and a single drain pad) on the semiconductor chip 120. However, such chip-internal metallization layer would increase R_{DS(on)} of the semiconductor chip 120. It would further increase R_{DS(on)} of the semiconductor package more than the off-chip RDL of the organic substrate, since it could not be fabricated with a thickness equal to the thickness of the off-chip RDL. Since the R_{DS(on)} of the semiconductor package is one of the most important device specification, organic carriers 140 (organic substrates) are becoming increasingly important in modern packaging technologies.

However, organic substrates such as, e.g., laminate-based substrates or MIS exclude soldering at temperatures equal to or greater than approximately 260°C. In particular, it is difficult to carry out semiconductor chip attach to the carrier 140 by soldering and/or heatsink 260 attach to the semiconductor chip 120 by soldering.

Therefore, the semiconductor chip 120 may be attached to the carrier 140 by low temperature die attach techniques such as by the use of electrically conductive adhesive or sinter paste. Generally, in particular if the carrier 140 is not as temperature critical as described above, the semiconductor chip 120 may also be soldered to the carrier 140 (e.g., if the carrier 140 comprises or is based on a ceramic carrier or a leadframe).

The heatsink 260 is bonded to the semiconductor chip 120 by a bonding material 290. The bonding material 290 may, e.g. be an adhesive (i.e., glue) or a paste. For example, the bonding material 290 may be an adhesive or a paste which cure at temperatures lower than 260°C or 240°C or 220°C or 200°C.

In some examples the bonding material 290 may be electrically insulating. In other examples the bonding material may, e.g., electrically conducting. For example, the bonding material 290 may be an electrically conductive adhesive or a sinter paste containing metal particles, e.g. an Ag or Cu sinter paste.

Especially for heatsink attach with adhesive or paste instead of solder, a stable assembly is necessary because of the missing self-alignment effects of solder. The wire loops 280, 280_1, 280_2 allow such controlled and stable assembly of the heatsink 260. In particular, a defined and constant height H of the heatsink 260 above the carrier 140 may be set, for example.

Further, the wire loops 280, 280_1, 280_2 allow to electrically contact the heatsink 260 to the carrier 140. That way, the backside (second surface 120B) of the semiconductor chip 120 may be held on a defined potential, e.g. ground potential or source potential. A defined potential at the backside of the semiconductor chip 120, in particular a GaN-type chip, is beneficial for a high and reproducible electrical performance of the semiconductor chip 120.

Figures 3A to 3D illustrate an example of a semiconductor package 200_2 according to the second aspect of the disclosure.

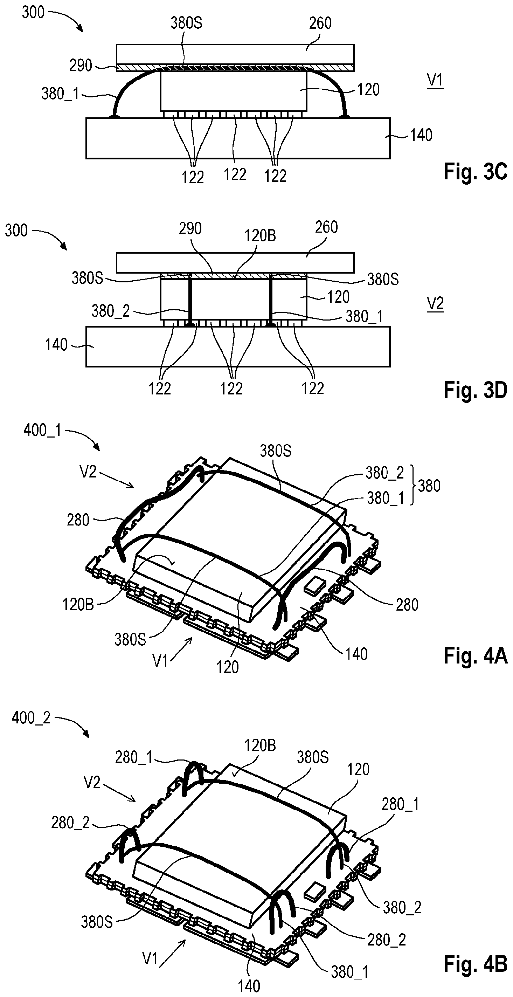

Semiconductor package 300 includes at least one wire loop 380 (here, by way of example, two or, in general, a plurality of wire loops 380_1, 380_2 are depicted) which is bonded to the carrier 140 and has a loop section 380S connected to the heatsink 260. In contrast to wire loops 280, 280_1, 280_2, the wire loop 380, 380_1, 380_2 passes over the semiconductor chip 120 and extends between the semiconductor chip 120 and the heatsink 260 (Figures 3C and 3D).

The wire loop 380 may be of the same material(s), as described for wire loop 280. Further, the wire loop 380 may be bonded to the carrier 140 the same way as described for wire loop 280. Reference is made to the above description.

Different from the semiconductor package 200, the wire loop 380 defines a distance between the second surface 120B of the semiconductor chip 120 and the heatsink 260. More specifically, the wire of the wire loop 380 has a specific thickness (diameter). As the wire loop 380 may be used as a spacer between the semiconductor chip 120 and the heatsink 260 (e.g. a clip), this thickness (diameter) may be equal to the distance between the second surface 120B of the semiconductor chip 120 and the heatsink 260.

In other words the wire loop(s) 380, 380_1, 380_2 may be used to realize a defined BLT (Bond Line Thickness) between the semiconductor die 120 and the heatsink 260. For the reliability of the package 300, the magnitude and uniformity of the BLT is important. The control of the BLT by the wire loop(s) 380, 380_1, 380_2 allows to realize a defined and across the second surface 120B of the chip constant BLT during heatsink attach, which improves a reproducible performance of the package.

A proper BLT control is especially needed if the bond material 290 for heatsink attach is of an adhesive or a paste, which do not provide self-alignment functionality. However, in general, it is also possible that the bond material 290 comprises or is of solder.

According to the second aspect of this disclosure, the semiconductor chip 120 may be a lateral device as described before. In other examples according to the second aspect of the disclosure, the semiconductor chip 120 may be a vertical device. In a vertical device, the main direction of load current flow is in a direction between the first surface 120A and the second surface 120 of the semiconductor chip 120. Also in this case, the semiconductor chip 120 may be a power transistor chip.

According to the second aspect of the disclosure, especially if the semiconductor chip 120 is a vertical device, the semiconductor chip 120 may optionally contain one or more chip pads 322 on the second surface 120B of the semiconductor chip 120. For example, the chip pad 322 may be a drain pad and the first surface 120A of the semiconductor chip 120 may contain a source pad and a gate pad, for example.

Differently put, the concept of BLT control according to the second aspect of the disclosure can be used but is not limited for lateral semiconductor devices such as, e.g., GaN chips. Rather, BLT control by using wire loops 380, 380_1, 380_2 as spacer(s) can be applied to any semiconductor package having a semiconductor chip 120 and a heatsink 260 attached to the semiconductor chip 120. The wire loop(s) 380, 380_1, 380_2 may or may not provide electrical functionality. For example, the wire loop(s) 380, 380_1, 380_2 may hold the heatsink 260 on a defined potential. It is also possible that the wire loop(s) 380, 380_1, 380_2 both mechanically and electrically connect to the chip pad 322 and thus, may be used for load current routing from the chip pad 322 to the carrier 140.

In other examples according to the second aspect of the disclosure, the semiconductor chip 12 is a logic chip, in particular a power logic chip.

Returning to Figures 3A and 3B, the wire loop(s) 380, 380_1, 380_2 may have two ends which are bonded to the carrier 140 at opposite sides of the semiconductor chip 120. After bonding the wire loop(s) 380, 380_1, 380_2 to the carrier 140, the wire loop(s) 380, 380_1, 380_2 may not need to contact the second surface 120B of the semiconductor chip 120. However, during heatsink attach, bonding material 290 is applied between the second surface 120B of the semiconductor chip 120 and the heatsink 260 (e.g. clip), and the heatsink 260 is placed down on the semiconductor chip 120 by applying some pressure. This down placement of the heatsink 260 causes the wire loop(s) 380, 380_1, 380_2 to deform and act as a spacer, see Figures 3C and 3D.

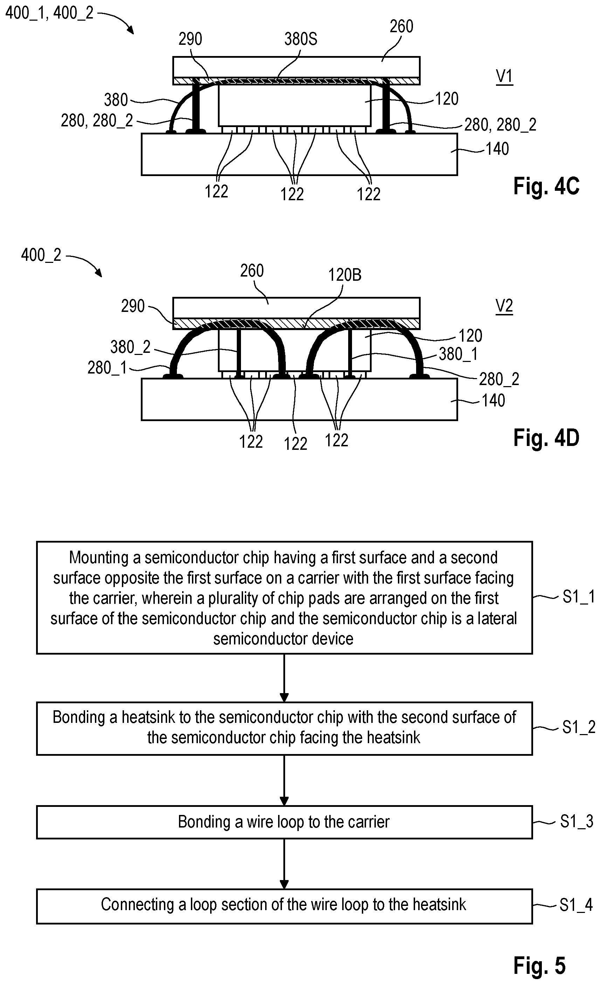

Figures 4A to 4D illustrate semiconductor packages 400_1, 400_2 according to the first aspect and the second aspect of the disclosure. That is, the semiconductor packages 400_1, 400_2 include wire loop(s) 280, 280_1, 280_2 which are arranged beside the semiconductor chip 120 and include wire loop(s) 380, 380_1, 380_2 passing over the semiconductor chip 120 and extending between the semiconductor chip 120 and the heatsink 260.

In semiconductor packages 400_1, 400_2, the position of the heatsink 260 is controlled by the wire loop(s) 380, 380_1, 380_2. Thus, the semiconductor packages 400_1, 400_2 feature the BLT control as described above. In general, reference is made to the description of the second aspect of the disclosure and Figures 3A to 3D to avoid reiteration.

The wire loop(s) 280, 280_1, 280_2 arranged beside the semiconductor chip 120 may be used for electrical contact between the heatsink 260 and the carrier 140 and/or for the reasons described above in connection with Figures 2A to 2D. In general, reference is made to the description of the first aspect of the disclosure to avoid reiteration.

Referring to Figure 5, a method of manufacturing a semiconductor package may include, at S1_1, mounting a semiconductor chip having a first surface and a second surface opposite the first surface on a carrier with the first surface facing the carrier, wherein a plurality of chip pads are arranged on the first surface of the semiconductor chip, which is a lateral semiconductor device.

At S1_2, a heatsink is bonded to the semiconductor chip with the second surface of the semiconductor chip facing the heatsink.

At S1_3, a wire loop is bonded to the carrier.

At S1_4, a loop section of the wire loop is connected to the heatsink.

As described before, the loop section may be arranged beside the semiconductor chip (see, e.g., Figures 2A to 2D) or the loop section of the wire loop may pass over the semiconductor chip (see, e.g., Figures 3A to 3D).

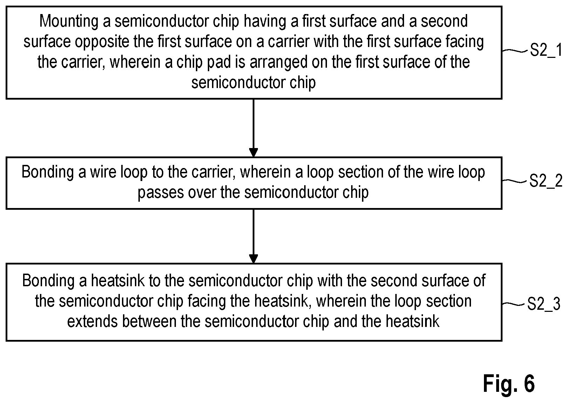

Referring to Figure 6, a method of manufacturing a semiconductor package may include, at S2_1, mounting a semiconductor chip having a first surface and a second surface opposite the first surface on a carrier with the first surface facing the carrier, wherein a chip pad is arranged on the first surface of the semiconductor chip (which may, e.g., be a lateral device, a vertical device and/or a logic chip).

At S2_2, a wire loop is bonded to the carrier, wherein a loop section of the wire loop passes over the semiconductor chip.

At S2_3, a heatsink is bonded to the semiconductor chip with the second surface of the semiconductor chip facing the heatsink, wherein a loop section of the wire loop extends between the semiconductor chip and the heatsink.

The methods of Figure 5 and Figure 6 may be combined by using wire loops arranged beside the semiconductor chip according to the flowchart of Figure 5 for making electrical contact between the carrier and the heatsink and by additionally using wire loops which pass over the semiconductor chip according to the flowchart of Figure 6 for BLT control.

In general, a plurality of semiconductor chips 120 may be arranged under the heatsink (not shown). For example, one or more wire loop sections 380S of corresponding wire loops 380 may pass over each of the semiconductor chips 120. The heatsink 260 may be a single, common heatsink 260 arranged over the plurality of semiconductor chips 120.

### EXAMPLES

The following examples pertain to further aspects of the disclosure:

Example 1 is a semiconductor package which includes a semiconductor chip having a first surface and a second surface opposite the first surface. The semiconductor chip is a lateral semiconductor device. A plurality of chip pads is arranged on the first surface of the semiconductor chip. The semiconductor chip is mounted on a carrier, wherein the semiconductor chip is bonded to the carrier with the first surface facing the carrier. A heatsink is disposed over the semiconductor chip. The heatsink is bonded to the semiconductor chip with the second surface of the semiconductor chip facing the heatsink. A conductor loop is bonded to the carrier, wherein a loop section of the conductor loop is connected to the heatsink, wherein the conductor is a wire or a ribbon.

In Example 2, the subject matter of Example 1 can optionally include wherein the loop section is arranged beside the semiconductor chip.

In Example 3, the subject matter of Example 1 can optionally include wherein the loop section passes over the semiconductor chip and extends between the semiconductor chip and the heatsink.

In Example 4, the subject matter of Example 3 can optionally include wherein a thickness of a conductor forming the conductor loop defines a distance between the second surface of the semiconductor chip and the heatsink.

In Example 5, the subject matter of Example 3 or 4 can optionally further include a further conductor loop bonded to the carrier, wherein a further loop section of the further conductor loop is connected to the heatsink, wherein the further loop section is arranged beside the semiconductor chip.

In Example 6, the subject matter of any of the preceding Examples can optionally include wherein the carrier comprises an organic substrate or a leadframe.

In Example 7, the subject matter of any of the preceding Examples can optionally include wherein a bond material used for bonding the heatsink to the semiconductor chip comprises one or more of the group consisting of solder, electrically conductive adhesive or sinter paste.

Example 8 is a semiconductor package which includes a semiconductor chip having a first surface and a second surface opposite the first surface. A chip pad is arranged on the first surface of the semiconductor chip. The semiconductor chip is mounted on a carrier, wherein the semiconductor chip is bonded to the carrier with the first surface facing the carrier. A heatsink is disposed over the semiconductor chip. The heatsink is bonded to the semiconductor chip with the second surface of the semiconductor chip facing the heatsink. A conductor loop is bonded to the carrier, wherein a loop section of the conductor loop passes over the semiconductor chip and extends between the semiconductor chip and the heatsink, wherein the conductor is a wire or a ribbon.

In Example 9, the subject matter of Example 8 can optionally include wherein a thickness of a conductor forming the conductor loop defines a distance between the second surface of the semiconductor chip and the heatsink.

In Example 10, the subject matter of Example 8 or 9 can optionally include wherein a plurality of conductor loops are bonded to the carrier, wherein a loop section of each of the plurality of the conductor loops passes over the semiconductor chip and extends between the semiconductor chip and the heatsink.

In Example 11, the subject matter of any of the Examples 8 to 10 can optionally include wherein a further conductor loop bonded to the carrier, wherein a further loop section of the further conductor loop is connected to the heatsink, wherein the further loop section is arranged beside the semiconductor chip.

In Example 12, the subject matter of any of the Examples 8 to 11 can optionally include wherein the semiconductor chip is a lateral semiconductor device having a plurality of chip pads arranged on the first surface of the semiconductor chip.

In Example 13, the subject matter of any of the Examples 8 to 12 can optionally include wherein the carrier comprises an organic substrate or a leadframe.

In Example 14, the subject matter of any of the Examples 8 to 13 can optionally include wherein a bond material used for bonding the heatsink to the semiconductor chip comprises one or more of the group consisting of solder, electrically conductive adhesive or sinter paste.

In Example 15, the subject matter of any of the preceding Examples can optionally include wherein the semiconductor chip is a power device, in particular a power transistor.

In Example 16, the subject matter of any of the preceding Examples can optionally include wherein the heatsink comprises a clip.

Example 17 is a method of manufacturing a semiconductor package, the method comprising mounting a semiconductor chip having a first surface and a second surface opposite the first surface on a carrier with the first surface facing the carrier, wherein a plurality of chip pads are arranged on the first surface of the semiconductor chip and the semiconductor chip is a lateral semiconductor device; bonding a heatsink to the semiconductor chip with the second surface of the semiconductor chip facing the heatsink; bonding a conductor loop to the carrier; and connecting a loop section of the conductor loop to the heatsink.

In Example 18, the subject matter of Example 17 can optionally include wherein the loop section is arranged beside the semiconductor chip.

In Example 19, the subject matter of Example 17 or 18 can optionally include wherein bonding the conductor loop to the carrier is carried out such that a loop section of the conductor loop passes over the semiconductor chip; and bonding the heatsink to the semiconductor chip is carried out such that the loop section extends between the semiconductor chip and the heatsink.

In Example 20, the subject matter of Example 19 can optionally further include bonding a further conductor loop to the carrier, wherein a further loop section of the further conductor loop is connected to the heatsink, wherein the further loop section is arranged beside the semiconductor chip.

Example 21 is a method of manufacturing a semiconductor package, the method comprising mounting a semiconductor chip having a first surface and a second surface opposite the first surface on a carrier with the first surface facing the carrier, wherein a chip pad is arranged on the first surface of the semiconductor chip; bonding a conductor loop to the carrier, wherein a loop section of the conductor loop passes over the semiconductor chip; and bonding a heatsink to the semiconductor chip with the second surface of the semiconductor chip facing the heatsink, wherein the loop section extends between the semiconductor chip and the heatsink.

In Example 22, the subject matter of Example 21 can optionally further include bonding a plurality of conductor loops to the carrier, wherein a plurality of loop sections of the plurality of conductor loops passes over the semiconductor chip.

In Example 23, the subject matter of Example 22 can optionally further include bonding a further conductor loop to the carrier, wherein a further loop section of the further conductor loop is arranged beside the semiconductor chip; and connecting the further loop section to the heatsink.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. A semiconductor package, comprising:
a semiconductor chip having a first surface and a second surface opposite the first surface, the semiconductor chip being a lateral semiconductor device;
a plurality of chip pads arranged on the first surface of the semiconductor chip;
a carrier on which the semiconductor chip is mounted, the semiconductor chip being bonded to the carrier with the first surface facing the carrier;
a heatsink disposed over the semiconductor chip, the heatsink being bonded to the semiconductor chip with the second surface of the semiconductor chip facing the heatsink; and
a conductor loop bonded to the carrier, wherein a loop section of the conductor loop is connected to the heatsink, wherein the conductor is a wire or a ribbon.

2. The semiconductor package of claim 1, wherein the loop section is arranged beside the semiconductor chip.

3. The semiconductor package of claim 1, wherein the loop section passes over the semiconductor chip and extends between the semiconductor chip and the heatsink.

4. The semiconductor package of claim 3, wherein a thickness of a conductor forming the conductor loop defines a distance between the second surface of the semiconductor chip and the heatsink.

5. The semiconductor package of claim 3 or 4, further comprising:
a further conductor loop bonded to the carrier, wherein a further loop section of the further conductor loop is connected to the heatsink, wherein the further loop section is arranged beside the semiconductor chip.

6. The semiconductor package of any of the preceding claims, wherein the carrier comprises an organic substrate or a leadframe.

7. The semiconductor package of any of the preceding claims, wherein a bond material used for bonding the heatsink to the semiconductor chip comprises one or more of the group consisting of solder, electrically conductive adhesive or sinter paste.

8. A semiconductor package, comprising:
a semiconductor chip having a first surface and a second surface opposite the first surface;
a chip pad arranged on the first surface of the semiconductor chip;
a carrier on which the semiconductor chip is mounted, the semiconductor chip being bonded to the carrier with the first surface facing the carrier;
a heatsink disposed over the semiconductor chip, the heatsink being bonded to the semiconductor chip with the second surface of the semiconductor chip facing the heatsink; and
a conductor loop bonded to the carrier, wherein a loop section of the conductor loop passes over the semiconductor chip and extends between the semiconductor chip and the heatsink, wherein the conductor is a wire or a ribbon.

9. The semiconductor package of claim 8, wherein a thickness of a conductor forming the conductor loop defines a distance between the second surface of the semiconductor chip and the heatsink.

10. The semiconductor package of claim 8 or 9, wherein a plurality of conductor loops are bonded to the carrier, wherein a loop section of each of the plurality of the conductor loops passes over the semiconductor chip and extends between the semiconductor chip and the heatsink.

11. The semiconductor package of any of claims 8 to 10, further comprising:
a further conductor loop bonded to the carrier, wherein a further loop section of the further conductor loop is connected to the heatsink, wherein the further loop section is arranged beside the semiconductor chip.

12. The semiconductor device of any of claims 8 to 11, wherein the semiconductor chip is a lateral semiconductor device having a plurality of chip pads arranged on the first surface of the semiconductor chip.

13. The semiconductor package of any of claims 8 to 12, wherein the carrier comprises an organic substrate or a leadframe.

14. The semiconductor package of any of claims 8 to 13, wherein a bond material used for bonding the heatsink to the semiconductor chip comprises one or more of the group consisting of solder, electrically conductive adhesive or sinter paste.

15. The semiconductor package of any of the preceding claims, wherein the semiconductor chip is a power device, in particular a power transistor.

16. The semiconductor package of any of the preceding claims, wherein the heatsink comprises a clip.
